# EUROPEAN PATENT APPLICATION

(11) **EP 3 705 597 A1**
(43) Date of publication of application: **09.09.2020**
(21) Application number: 20160763.7
(22) Date of filing: 03.03.2020
(51) Int. Cl.: C23C 4/02, C23C 4/11, C23C 4/12, C23C 4/134, C23C 28/04, C23C 28/00, C23C 14/02, C23C 14/08

(54) **THERMAL BARRIER COATING WITH IMPROVED ADHESION**

(30) Priority: 05.03.2019 US 201916293338
(71) Applicant: United Technologies Corporation, Farmington, CT 06032 (US)
(72) Inventor: RIDGEWAY, Neil B., South Windsor, CT Connecticut 06074 (US)
(74) Representative: Dehns

(57) **Abstract**

A metal article includes a metal substrate (12) and a thermal barrier coating (40). A thermally grown mixed oxide layer (44) between the metal substrate (12) and the thermally grown mixed oxide layer (44) enhances the spallation resistance of the thermal barrier coating (40) on the metal substrate (12) of metal article. In an embodiment, the thermal barrier coating (40) is about 51 weight percent gadolinia and about 49 weight percent yttria partially stabilized zirconia.

## Description

### BACKGROUND

The invention relates to thermal barrier coatings made from ceramic materials on metallic parts. In particular, the invention relates to a thermal procedure that improves the spallation resistance of a thermal barrier coating.

Metal components in the hottest section of modern gas turbine engines typically operate at temperatures that exceed their melting point. To circumvent this problem, the components are prevented from overheating by cooling air flowing through internal passageways in the components and by having external surfaces that are insulated with ceramic thermal barrier coatings. The addition of thermal barrier coatings reduces the amount of cooling air required and can substantially increase engine efficiency.

Common ceramic thermal barrier coatings are zirconias. Zirconias, in particular, yttria stabilized zirconia, containing 7 weight percent yttria, e.g., 7YSZ offer significant thermal protection and, in addition, are resistant to spallation, presumably due to the high fracture toughness of the material. The thermal conductivities of zirconia thermal barrier coatings, however, are not as satisfactory as gadolinia zirconia coatings. In particular, gadolinia zirconia coatings containing up to 59 weight percent GdO₃ and 41 weight percent ZrO₂ exhibit thermal conductivities that are about one half the thermal conductivity of zirconia coatings. Unfortunately, they can sometimes exhibit lower spallation resistance that limits their application.

Commonly owned U.S. Patent No. 7,326,470 to Ulion et al. teaches that a 7YSZ layer between a GdZr thermal barrier coating and an underlying superalloy substrate can increase the spallation resistance of the coating but also increases weight and adds cost of an extra processing step.

### SUMMARY

A metal article includes a metallic substrate and a spallation resistant ceramic coating, such as a thermal barrier coating. A thermally grown mixed oxide layer between the metal substrate and the thermal barrier coating enhances the spallation resistance of the coating. In an embodiment, the thermally grown mixed oxide comprises less than 90 percent alpha alumina and the thermal barrier coating is about 51 weight percent gadolinia and about 49 weight percent yttria partially stabilized zirconia.

In another embodiment, a method of forming a spallation resistant thermal barrier coating on a metal substrate includes cleaning the substrate and preheating the substrate to a temperature suitable for the deposition of a thermal barrier coating according to a preheating schedule that allows a thermally grown mixed oxide layer to form on the substrate. A ceramic thermal barrier coating deposited on the thermally grown mixed oxide layer forms a spallation resistant coating.

### BRIEF DESCRIPTION OF THE DRAWINGS

FIG. 1 is a schematic cross-section of a prior art yttria stabilized zirconia coating on a thermally grown oxide (TGO) layer.
FIG. 2 is a schematic cross-section of a prior art gadolinia zirconia (GdZr) coating on a thermally grown oxide layer.
FIG. 3 is a schematic cross-section of a prior art GdZr coating on a TGO layer with a 7YSZ layer interspersed between a TGO layer and GdZr coating.
FIG. 4 is a schematic cross-section of a GdZr coating on a mixed oxide TGO layer of the invention.
FIG. 5 is a method to form a GdZr coating of the invention.

### DETAILED DESCRIPTION

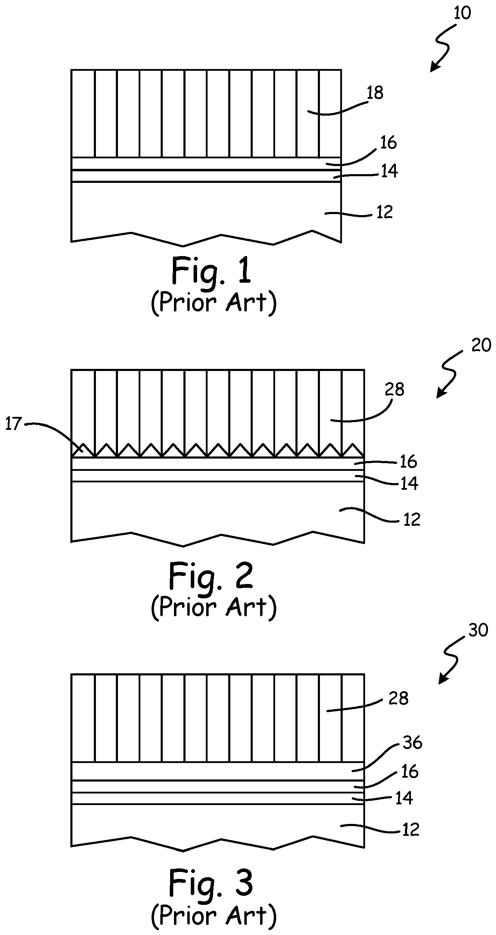

A schematic cross-section of an yttria stabilized zirconia thermal barrier coating known in the art is shown in FIG. 1. Thermal barrier coating 10 is applied to a metal substrate 12. Metal substrate 12 may be a nickel base, cobalt base, iron base superalloy or mixtures thereof or a titanium alloy. Optional bond coat metal 14 is on substrate 12. Bond coat 14 may be a MCrAlY bond coat where M is Ni, Co or mixtures thereof or an aluminide which may include a platinum group metal. Alternatively, the substrate may comprise a material capable of forming an adherent alpha alumina layer and thus may not need a metallic bond coat. Layer 16 is an alpha alumina (Al₂O₃) thermally grown oxide (TGO) layer. TGO layer 16 may form during preheat to the deposition temperature. The TGO layer is required for successful adhesion of thermal barrier layer 18 to bond coat 14 or substrate 12. Thermal barrier layer 18 may be a zirconia layer, preferably yttria stabilized zirconia containing 7 weight percent yttria for enhanced fracture toughness (7YSZ).

A preferred means of forming 7YSZ layer 18 is by electron beam physical vapor deposition (EBPVD). As schematically indicated in FIG. 1, the vertical lines in layer 18 represent vertical grain boundaries or separations that enhance vertical microcrack formation during thermal cycling that increase the lateral compliance and minimize stress configurations leading to coating spallation. YSZ thermal barrier coating layer 18 may, alternatively, be applied by other thermal spray processes including but not limited to, air plasma spray (APS), low pressure plasma spray (LPPS), high velocity oxy fuel (HVOF), detonation gun (D Gun) and sputtering.

Commonly owned U.S. Pat. No. 4,321,311 to Strangman teaches the above-mentioned YSZ thermal barrier coat.

A lower thermal conductivity thermal barrier coating is gadolinia zirconia (GdZr), preferably about 51 weight percent gadolinia (Gd₂O₃) and about 49 weight percent zirconia (ZrO₂). A schematic of a GdZr thermal barrier coating is shown in FIG. 2. GdZr coating 20 comprises substrate 12, and optional bond coat 14 that have been described in reference to FIG. 1. Thermally grown oxide layer (TGO) 16 may be identical to layer 16 in FIG. 1 since the preheat schedule for GdZr layer 28 deposition is the same as the preheat schedule used for deposition of 7YSZ layer 18 in FIG. 1. GdZr layer 28 contains vertical grain boundaries and separations as schematically indicated by vertical lines that enhance vertical microcracking and suppress spallation during thermal cycling. As indicated by the irregular interface between GdZr layer 28 containing voids 17 (exaggerated for clarity) and standard thermally grown oxide (TGO) layer 16, GdZr may not adhere as well to a standard alpha alumina TGO layer. Alpha alumina as a bond coat is not compatible with a thermally insulative GdZr coating.

Improved adhesion of GdZr on a metallic bond coat or metallic substrate has been provided by interposing an yttria stabilized zirconia layer 36 between layer GdZr thermal barrier layer 28 and bond coat 16. This is taught in above-mentioned U.S. Patent No. 7,326,470 to Ulion et al. and is schematically illustrated as thermal barrier coating 30 in FIG. 3. Thermal barrier coating 30 on substrate 12 comprises optional bond coat 14 as described earlier. Interposed layer 36 comprises an yttria stabilized zirconia layer (YSZ), preferably formed by EBPVD, on optional bond coat layer 16 on substrate 14. The thickness of YSZ layer 36 is about 1 micron to about 2 mils (51 microns). As noted, the addition of YSZ layer 36 between bond coat layer 16 and GdZr thermal barrier coat layer 28 adds weight and extra processing steps.

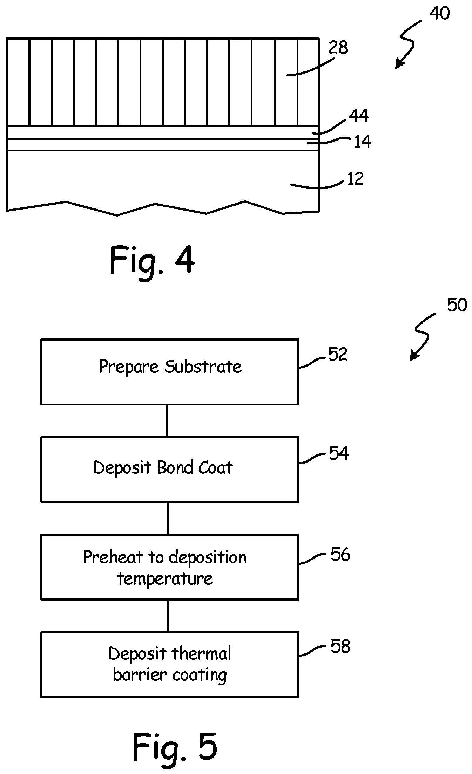

The GdZr thermal barrier coating (TBC) of the invention on metal substrate 12 is shown in FIG. 4. TBC 40 comprises optional metal bond coat 14 as described earlier and GdZr layer 28. An adherent thermally grown complex mixed oxide layer 44 can be grown on bond coat 14 or substrate 12 to provide a critical link between metal substrate 12 and TBC 40. Thermally grown mixed oxide layer 44 is responsible for allowing GdZr thermal barrier layer 28 to exhibit increased adhesion during thermal cycling in service with reduced spalling. Coating 28 has the requisite vertical grain boundaries and separations and resulting vertical microcracks that relieve interfacial stresses by increasing the compliance of the coating thereby resisting spallation while providing required thermal protection.

The difference between the standard, thermally grown oxide layer 16 and thermally grown mixed oxide layer 44 of the invention lies in the differences in kinetics of formation of both layers. In the illustrated embodiment, the time to reach the preheat temperature for GdZr deposition was critical and was increased by three minutes.

The increased heat up time allows a complex thermally grown oxide with a mixed oxide microstructure to form, which results in an acceptable adhesion of EBPVD GdZr coatings formed on the mixed oxide layer of the invention. Thermally grown mixed oxide layer 44 is formed by the diffusion of elements in addition to Al from MCrAlY bond coat 14 or, in the absence of bond coat 14, from superalloy substrate 12. Thermally grown mixed oxide layer 44 includes primarily alpha alumina but also contains other oxides including chromium oxide, cobalt oxide, and nickel oxide. The additional oxides change the character of the alpha alumina and improve compatibility of the alpha alumina with the GdZr. The additional oxide can reduce the reaction between the GdZr and the alpha alumina which promoted premature failure. Acceptable adhesion can be provided when thermally grown mixed oxide layer 44 has less than 90 percent alpha alumina and greater than 60 percent alpha alumina. Preferably, thermally grown mixed oxide layer has between 70 and 75 percent alpha alumina.

Method 50 of forming the thermal barrier coating of the invention is shown in FIG. 5. The first step is to clean and otherwise prepare the substrate surface. (Step 52). Conventional cleaning and preparation is by methods known to those in the art of thermal and high velocity coating deposition. Processes such as mechanical abrasion through vapor and air blast processes using dry or liquid carried abrasive particles impacting the surface are standard. Chemical methods such as acid and caustic surface removal at normal and elevated temperatures are also standard.

In the next step, an optional bond coat is deposited. (Step 54). Bond coats may be MCrAlY bond coats where M is Ni, Co or mixtures thereof or an aluminide which may also include one or more precious metals.

The next step is to preheat the substrate to a deposition temperature in order to form thermally grown mixed oxide layer 44. (Step 56). In an embodiment, the deposition temperature may be between 1875° F (1024° C) and about 1920° F (1049° C) and the heat up time may be between about 15 minutes and 18 minutes. A final step is to deposit a GdZr thermal barrier layer. (Step 58). Deposition may be by thermal spray processes such as air plasma spray (APS), low pressure plasma spray (LPPS), high velocity oxy fuel (HVOF), detonation gun (D-Gun), sputtering, electron beam physical vapor depositioin (EBPVD) and others known in the art. EBPVD is preferred due to the vertical grain boundary/microcrack microstructure resulting from this form of coating.

### Discussion of Possible Embodiments

The following are non-exclusive descriptions of possible embodiments of the present invention.

A metal article includes a metal substrate, a thermal barrier coating (TBC), and a thermally grown mixed oxide (TGMO) layer between the metallic substrate and the TBC comprising less than 90 percent alpha alumina and greater than 60 percent alpha alumina.

The metal article of the preceding paragraph can optionally include, additionally and/or alternatively any, one or more of the following features, configurations and/or additional components:
The thermal barrier coating may be gadolinia zirconia GdZr.

The thermal barrier coating may be about 59 weight percent gadolinia and the remainder substantially zirconia.

The thermal barrier coating may be applied by thermal spraying, sputtering, or electron beam physical vapor deposition (EBPVD).

The thermal barrier coating may be deposited by EBPVD.

The substrate may be a nickel-based, cobalt-based, or iron-based superalloy or mixtures thereof or a titanium alloy.

The thermally grown mixed oxide layer may be formed during the preheat process while the substrate is heated to the thermal barrier coat deposition temperature.

The preheat process comprises a heat up time of about 15 minutes to about 18 minutes to a thermal barrier coating deposition temperature of between about 1875° F (1024° C) and about 1925° F (1052° C).

The thermal barrier coating thickness may be between about 1 mil (25 microns) and about 15 mils (381 microns).

The thermally grown mixed oxide layer may have a thickness of between about 0.1 micron and about 1.0 micron.

The thermally grown mixed oxide layer may also comprise oxides selected from the group consisting of chromium oxide, iron oxide, and nickel oxide.

The thermally grown mixed oxide layer may have 75 percent or less alpha alumina.

The thermally grown mixed oxide layer may have between 70 and 75 percent alpha alumina.

Although the present invention has been described with reference to preferred embodiments, workers skilled in the art will recognize that changes may be made in form and detail without departing from the spirit and scope of the invention.

## Claims

1. A metal article comprising:
a metal substrate (12);
a thermal barrier coating (TBC) (40); and
a thermally grown mixed oxide (TGMO) layer (44) between the metal substrate (12) and the thermal barrier coating (40), wherein the thermally grown mixed oxide layer (44) comprises less than 90 percent alpha alumina and greater than 60 percent alpha alumina.

2. The article of claim 1, wherein the thermal barrier coating (40) is gadolinia zirconia (GdZr).

3. The article of claim 2, wherein the thermal barrier coating (40) is about 59 weight percent gadolinia and the remainder substantially zirconia.

4. The article of any preceding claim, wherein the thermal barrier coating (40) is applied by thermal spraying, sputtering, or electron beam physical vapor deposition (EBPVD).

5. The article of any of claims 1 to 3, wherein the thermal barrier coating (40) is deposited by electron beam physical vapor deposition (EBPVD).

6. The article of any preceding claim, wherein the substrate (12) is a nickel-based, cobalt based, or iron based superalloy or mixtures thereof or a titanium alloy.

7. The article of any preceding claim, wherein the thermally grown mixed oxide layer (44) is formed during a preheat process while the substrate (12) is heated to a thermal barrier coating deposition temperature.

8. The article of claim 7, wherein the preheat process comprises a heat up time of about 15 minutes to about 18 minutes to a thermal barrier coating deposition temperature of between about 1875° F (1024° C) and about 1925° F (1052° C).

9. The article of any preceding claim, wherein the thermal barrier coating (40) thickness is between about 1 mils (25 microns) and about 15 mils (381 microns).

10. The article of any preceding claim, wherein the thermally grown mixed oxide layer (44) has a thickness of between about 0.1 micron and about 1.0 micron.

11. The article of any preceding claim, wherein the thermally grown mixed oxide layer (44) further comprises oxides selected from the group consisting of chromium oxide, iron oxide, nickel oxide, and combinations thereof.

12. The article of any preceding claim, wherein the thermally grown mixed oxide layer (44) comprises 75 percent or less alpha alumina.

13. The article of any preceding claim, wherein the thermally grown mixed oxide layer (44) comprises between 70 and 75 percent alpha alumina.
